# EUROPÄISCHE PATENTSCHRIFT

(11) **EP 1 864 377 B1**
(45) Veröffentlichungstag und Bekanntmachung des Hinweises auf die Patenterteilung: **21.03.2012**
(21) Anmeldenummer: 06723566.3
(22) Anmeldetag: 21.03.2006
(51) Int. Cl.: H03B 11/02, H01T 9/00

(54) **MIKROWELLENGENERATOR**
MICROWAVE GENERATOR
GENERATEUR DE MICRO-ONDES

(30) Priorität: 26.03.2005 DE 102005013925
(43) Veröffentlichungstag der Anmeldung: 12.12.2007
(73) Patentinhaber: Diehl BGT Defence GmbH & Co.KG, 88662 Überlingen (DE)
(72) Erfinder: STARK, Robert, 91438 Bad Windsheim (DE)
(74) Vertreter: Diehl Patentabteilung
(86) Internationale Anmeldenummer: PCT/EP2006/002552
(87) Internationale Veröffentlichungsnummer: WO 2006/103007

(56) Entgegenhaltungen:
- DE-A1- 10 151 565
- DE-B3- 10 313 286

## Beschreibung

Die Erfindung betrifft einen Mikrowellengenerator gemäß dem Oberbegriff der Ansprüche 1 und 8. Ein solcher Mikrowellengenerator ist aus der DE 103 13 286 B3 bekannt.

Die Funktion eines solchen Mikrowellengenerators beruht darauf, dass eine Hochspannungsquelle, etwa eine gemäß dem Prinzip der Marx'schen Stoßspannungsschaltung parallel aufgeladene und dann in Serie geschaltene Kondensatorbatterie, über eine Funkenstrecke kurzgeschlossen und damit entladen wird. Infolge des Kurzschlusses entstehen stark oszillierende Entlade- oder Kurzschlussströme mit steiler Flanke, die eine Mischung sehr hoher Frequenzen enthalten, die in der Regel über eine Antenne als Mikrowellenenergie mit einem breitbandigen, vom Frequenzgemisch abhängigen Spektrum abgestrahlt werden. Dieses breitbandige Mikrowellenspektrum weist eine so hohe Energiedichte auf, dass in der Umgebung eines solchen Mikrowellengenerators der Funkverkehr zumindest beeinträchtigt und Eingangskreise elektronischer Schaltungen aufgrund von Resonanzeffekten gestört oder sogar zerstört werden können. Alternativ zur Verwendung einer Marx'schen Stoßspannungsschaltung kann auch ein explosionsstoffgetriebener Hochspannungsgenerator eingesetzt werden, der im Vergleich mit herkömmlichen Hochspannungsgeneratoren einen einzelnen Hochspannungspuls mit extrem hoher Pulsenergie zur Verfügung stellen kann.

Die Abstrahlung der Mikrowellenenergie beruht auf einem entladungsbedingten Resonanzeffekt. Den Zündelektroden, zwischen denen die Funkenstrecke ausgebildet ist, sind weitere resonierende Elektroden- oder Leiterstrukturen zugeordnet, in denen der beim Durchschlagen erzeugte Entladestromimpuls zu kräftigen Sprungoszillationen führt, deren Frequenzgemisch eine Resonanzüberhöhung nach Maßgaben der momentanen elektrisch wirksamen Geometrie des Resonators bzw. der Resonatorstruktur ist.

Der Mikrowellengenerator weist wie ausgeführt einen "damped sinusoid"-Resonator bestehend aus einer koaxialen Kapazität, die über eine Funkenstrecke entladen wird, auf. Die Kapazität bildet in Zusammenhang mit den physikalischen Eigenschaften des Schalterplasmas, das beim Zünden in der Funkenstrecke erzeugt wird, sowie der elektrischen Verschaltung einen Schwingkreis, der aus R, L und C besteht. Die Kapazität wird über eine Ladeimpedanz R, L auf Spannungen zwischen 100 kV bis in den MV-Bereich aufgeladen. Die zunehmende Ladespannung führt schließlich, dem Paschengesetz folgend, zum Durchbruch der Funkenstrecke, also zum Schließen des Plasmaschalters (spark gap). Der Durchbruch der Funkenstrecke kann auch gezielt durch einen geeigneten Triggermechanismus herbeigeführt werden. Die physikalischen Eigenschaften der Funkenstrecke (Durchbruchspannung, Umgebungsdruck, Elektroden- oder Gapabstand etc.) bestimmen maßgeblich das Schalt- oder Zündverhalten der Entladung und damit die Anstiegszeit und Pulsform, respektive die unterschiedlichen Frequenzanteile des erzeugten Hochspannungspulses.

Typischerweise werden Resonatoren der beschriebenen Art im Bereich von einigen 100 kV bis einigen MV mit Entladeströmen im Bereich einiger kA bis einigen 10 - 100 kA betrieben. Die erzeugten Pulsbreiten liegen typischerweise im Bereich von einigen wenigen bis einigen 10 ns. Die extrem hohen Ströme und Spannungen sowie die im Schalterplasma durch die Eigenimpedanz des Plasmas absorbierte Energie führen zu einer erheblichen lokalen Erosion an den Elektrodenflächen der Funkenstrecke. Eine übliche Elektrodenkonfiguration zeigt eine erste Elektrode, die an der in diesem Bereich z.B. kappen- oder halbkugelförmig gerundeten inneren Resonatorelektrode ausgebildet ist, sowie eine zweite Elektrode an der äußeren Resonatorelektrode zumeist in Form eines kleinen, kugelkappenförmigen Vorsprungs, wobei sich die beiden Elektroden bevorzugt unmittelbar mit geringem Abstand von z. B. wenigen Millimetern gegenüberliegen. Besonders stark korrodieren die Stellen der Elektrodenflächen, die gegeneinander den geringsten Abstand haben. Da die gegenwärtige Konfiguration der Elektroden wie beschrieben aus zwei halbkugelförmigen Elektroden besteht und sich damit die Entladung auf einen sehr eng begrenzten Bereich minimalen Abstands der Elektrodenoberflächen beschränkt, ist die Elektrodenerosion stark ausgeprägt und gegenwärtig das lebensdauerbegrenzende Element des Resonatorsystems. Die Energieankopplung durch das Schaltplasma auf die Elektrodenoberfläche führt zu lokalen Aufschmelzungen an "hot spots" an der Elektrodenoberfläche, wobei die Verlustleistung des Funkenstrecken-Schalters zu einer zusätzlichen Erhöhung der Elektrodentemperatur, die die Erosionsrate weiter erhöht, führt. Der starke Abbrand der Elektroden führt zwangsläufig zu einer Erhöhung des Funkenstreckenabstands und damit zu einer Veränderung der Durchbruchscharakteristik, was gleichzeitig eine Erhöhung der Puls-Anstiegszeit und damit eine Änderung des abgestrahlten Frequenzspektrums nach sich zieht. Konstante Verhältnisse über längere Zeit können infolge der eintretenden Erosion nicht erreicht werden.

Der Erfindung liegt damit das Problem zugrunde, einen Mikrowellengenerator anzugeben, bei dem die Erosionsrate an den Funkenstreckenelektroden verringert und ein stabiler und zuverlässiger Betrieb möglich ist.

Zur Lösung dieses Problems ist es vorgesehen, dass die Resonatorelektroden im Bereich der Funkenstrecke derart ausgebildet sind, dass sich ein zwei- oder dreidimensionaler Abschnitt mit im Wesentlichen konstanten, minimalen Elektrodenabstand ergibt.

Dadurch ist die Elektrodenoberfläche, die der Entladung zur Verfügung steht, gegenüber einer Geometrie, bei der es infolge der halbkugelförmigen Elektrodenausbildung letztlich nur einen Punkt minimalen Elektrodenabstands gibt, erheblich erhöht. Folglich ist ein zwei- oder dreidimensionaler Abschnitt mit im Wesentlichen konstantem, bezogen auf den gesamten Elektrodenabstand aber minimalem Elektrodenabstand, über dem die Funkenstrecke ausgebildet ist, vorgesehen. Nachdem die Entladung, abhängig vom Umgebungsgasdruck, statistisch verteilt an den Flächen der Elektroden mit dem kürzesten Elektrodenabstand zündet, steht infolge dieser Elektrodenausbildung eine wesentlich größere Elektrodenfläche zur Verfügung, über die die Zündung erfolgen kann. Selbst wenn es infolge eines Zündvorgangs in dem Bereich, in dem die Zündung erfolgte, zur Erosion kommt und folglich in diesem Bereich die ursprünglichen geometrischen Voraussetzungen nicht gegeben sind, stehen infolge der größeren Elektrodenabschnitte, zwischen denen der minimale Elektrodenabstand realisiert ist, noch ausreichend weitere Zündmöglichkeiten mit optimierter Elektrodengeometrie zur Verfügung. Durch die statistische Verteilung der Entladung auf eine größere Elektrodenfläche wird folglich die Standzeit der Elektrodenkonfiguration und damit die Lebensdauer und Zuverlässigkeit der Zündfunkenstrecke deutlich erhöht. Erosionseffekte spielen folglich kaum noch eine Rolle, infolge der auch auf längere Betriebsdauer gesehen konstanten Verhältnisse innerhalb der Funkenstrecke kommt es auch zu keinen Veränderungen in der Durchbruchscharakteristik und daraus resultierend des gesamten Generatorbetriebs.

Nach einer ersten Erfindungsausgestaltung weist wenigstens eine Resonatorelektrode eine vorspringende Ringstruktur auf. Es können auch mehrere zentralsymmetrische Ringstrukturen unterschiedlicher Radien, die also ineinanderliegen, vorgesehen sein wobei diese jeweils im gleichen Abstand zur gegenüberliegenden Resonatorelektrode liegen, mithin also die Zündung sowohl über die eine als auch die andere Ringstruktur zur gegenüberliegenden Elektrode erfolgen kann.

Während eine oder mehrere Ringstrukturen nur an einer Resonatorelektrode vorgesehen sein können, beispielsweise an der äußeren Elektrode, und die gegenüberliegende innere Resonatorelektrode in dem Bereich der Ringstruktur(en) beispielsweise ebenflächig zur Einhaltung des konstanten, minimalen Elektrodenabstands ausgebildet ist, ist es alternativ denkbar, an beiden Resonatorelektroden wenigstens eine oder gegebenenfalls mehrere zentralsymmetrische Ringstrukturen vorzusehen. In diesem Fall können die jeweiligen Ringstrukturen den gleichen Radius aufweisen und einander unmittelbar gegenüberliegen, die Funkenstrecke wäre also über die einander unmittelbar gegenüberliegenden Stirnflächen der Ringstrukturen realisiert. Alternativ ist es auch denkbar, dass die Ringstrukturen unterschiedliche Radien aufweisen und die eine in die andere eingreift, so dass sich die Funkenstrecke primär über die Seitenflächen der Ringstrukturen erstrecken würde.

Alternativ zur Verwendung von vorspringenden Ringstrukturen an beiden Resonatorelektroden ist es auch denkbar, eine solche Ringstruktur nur an einer Resonatorelektrode vorzusehen und an der anderen eine ringförmige Vertiefung auszubilden, in die die Ringstruktur eingreift. Ist die Geometrie der Ringstruktur wie auch der Vertiefung so gewählt, dass beide über die gesamte Eingriffstiefe konstanten, minimalen Abstand zueinander aufweisen, lässt sich eine sehr große Zündfläche realisieren.

Dabei kann sich generell eine Ringstruktur - und gegebenenfalls auch die ringförmige Vertiefung - zum freien Ende - bzw. zum Vertiefungsgrund hin - verjüngen.

Alternativ zur Verwendung einer oder mehrerer Ringstrukturen ist es gemäß einer zweiten Erfindungsausgestaltung auch möglich, an einer Resonatorelektrode eine zapfen- oder stempelartige vorspringende Struktur vorzusehen, die in eine Ausnehmung an der gegenüberliegenden Resonatorelektrode eingreift. Die Struktur ist zweckmäßigerweise rotationssymmetrisch, die Ausnehmung hohlzylindrisch. Bei einer zapfenförmigen Struktur sollte sich die Struktur und die Ausnehmung zu ihrem freien Ende bzw. zum Ausnehmungsgrund hin verjüngen, worüber sich unerwünschte Feldüberhöhungen, die zu einer unerwünschten Lokalisierung der Entladung und damit einer erhöhten Erosion führen würden, vermeiden lassen. Bevorzugt ist die zapfenförmige Struktur und die Ausnehmung an ihrem freien Ende bzw. im Ausnehmungsgrund gerundet ausgeführt.

Eine stempelartige Struktur kann beispielsweise zylindrisch ausgeführt sein, die Ausnehmung ist in diesem Fall hohlzylindrisch, wobei hier bevorzugt die Funkenstrecke über die gesamte Mantelfläche der stempelartigen Struktur und der Innenfläche der hohlzylindrischen Ausnehmung realisiert ist. Alternativ ist es auch denkbar, die stempelartige Struktur im Wesentlichen T-förmig auszubilden, wobei der den größten Radius aufweisende Ansatz der Struktur den geringsten Abstand zur hohlzylindrischen Ausnehmung aufweist und in diesem Bereich die Funkenstrecke realisiert ist.

Eine Alternative zur Verwendung einer Ausnehmung, die in eine insgesamt geschlossene, bevorzugt aus Vollmaterial bestehende Resonatorelektrode eingebracht ist, sieht vor, bei einer hohlen Resonatorelektrode eine kreisförmige Ausnehmung, also eine Durchbrechung vorzusehen, in die die zylindrische zapfenartige Struktur eingreift bzw. die von dieser durchsetzt wird. In diesem Fall bildet sich die Funkenstrecke zwischen der Berandung der kreisförmigen Ausnehmung und der gegenüberliegenden Seitenfläche der zapfenartigen Struktur aus. Der die Ausnehmung begrenzende Elektrodenrand kann dabei querschnittlich gesehen abgerundet ausgeführt sein.

Weitere Vorteile, Merkmale und Einzelheiten der Erfindung ergeben sich aus den im folgenden beschriebenen Ausführungsbeispielen sowie anhand der Zeichnung. Dabei zeigen:
- Fig. 1: eine Prinzipdarstellung eines erfindungsgemäßen Mikrowellengenerators,
- Fig.2: eine Teilansicht der Elektrodenausbildung im Bereich der Funkenstrecke einer ersten Ausführungsform,
- Fig. 3: eine Ausbildung der Elektroden im Bereich der Funkenstrecke nach einer zweiten Ausführungsform,
- Fig. 4: eine Ausbildung der Elektroden im Bereich der Funkenstrecke einer dritten Ausführungsform,
- Fig. 5: eine Ausbildung der Elektroden im Bereich der Funkenstrecke nach einer vierten Ausführungsform,
- Fig. 6: eine Ausbildung der Elektroden im Bereich der Funkenstrecke nach einer fünften Ausführungsform,
- Fig. 7: eine Ausbildung der Elektroden im Bereich der Funkenstrecke nach einer sechsten Ausführungsform,
- Fig. 8: eine Ausbildung der Elektroden im Bereich der Funkenstrecke nach einer siebten Ausführungsform,
- Fig. 9: eine Ausbildung der Elektroden im Bereich der Funkenstrecke nach einer achten Ausführungsform,
- Fig. 10: eine Ausbildung der Elektroden im Bereich der Funkenstrecke nach einer neunten Ausführungsform, und
- Fig. 11: eine Ausbildung der Elektroden im Bereich der Funkenstrecke nach einer zehnten Ausführungsform.

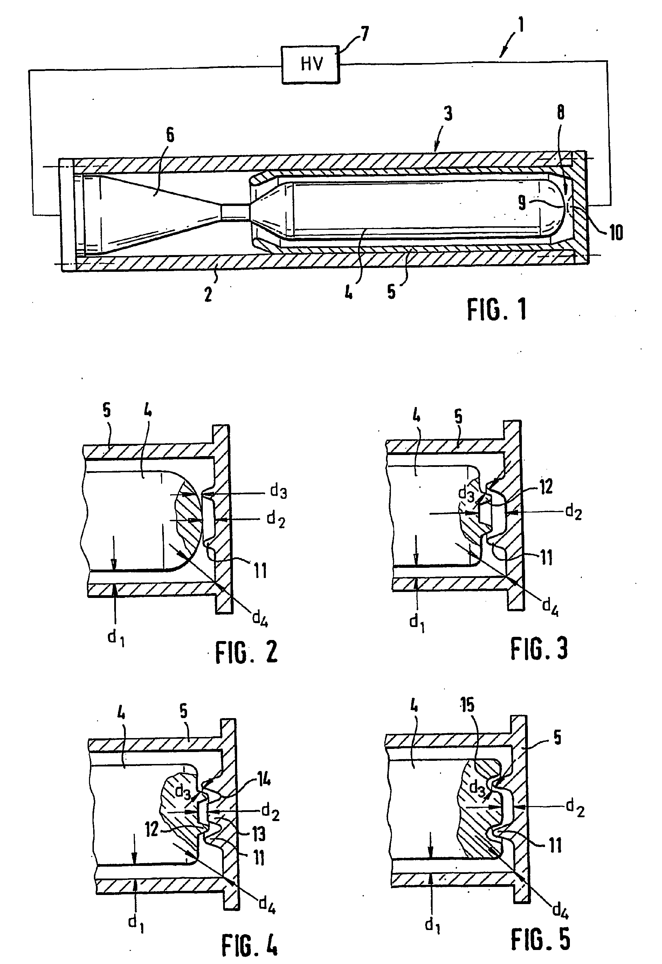

Fig. 1 zeigt einen erfindungsgemäßen Mikrowellengenerator 1, bestehend aus einem Gehäuse 2 aus Fiberglas oder dergleichen, in dem ein Resonator 3 vorgesehen ist. Der Resonator 3 besteht aus einer keulenförmigen inneren Resonatorelektrode 4 und einer diese radial beabstandet übergreifenden topfförmigen äußeren Resonatorelektrode 5. Die innere Resonatorelektrode 4 verjüngt sich zu ihrem linken Ende hin und ist mit einem konischen Abstrahlelement 6, über das die erzeugten Mikrowellen abgestrahlt werden, verbunden. Vorgesehen ist ferner eine Hochspannungsquelle 7, z.B. ein Marx'scher Stoßspannungsgenerator, über den die Hochspannung an den koaxialen Resonator 3 angelegt wird.

Die beiden Resonatorelektroden 4, 5 sind über eine Funkenstrecke 8 voneinander getrennt, wobei die Funkenstrecke über ein im Inneren des Gehäuses 2 befindliches gasförmiges Dielektrikum, bevorzugt SF₆/N₂-Gas isoliert ist. Die Funkenstrecke wird über zwei Funkenstreckenelektrodenabschnitte 9, 10 gebildet, wobei der Funkenstreckenelektrodenabschnitt 9 integraler Teil der inneren Resonatorelektrode 4 ist und in Fig. 1 an deren rechten Ende vorgesehen ist, während der Funkenstreckeelektrodenabschnitt 10 integraler Teil der topfförmigen äußeren Resonatorelektrode 5 ist.

Um nun Mikrowellen abzustrahlen, wird über die Hochspannungsquelle 7 die erforderliche Hochspannung angelegt, so dass die gegebene koaxiale Kapazität des Resonators 3 aufgeladen wird. Wird die Durchbruchsspannung der Funkenstrecke 8 erreicht, so zündet diese in dem Bereich, in dem die beiden Funkenstreckenelektrodenabschnitte 9, 10 den minimalen Abstand zueinander aufweisen. Infolge des Kurzschlusses entstehen stark oszillierende Entlade-oder Kurzschlussströme, es kommt durch entsprechende Anpassung des lmpedanzverhältnisses des Resonators zu einer gedämpften Sinusschwingung und der Abstrahlung der Mikrowellen über das Abstrahlelement 6.

Die Geometrie der Resonatorelektroden 4, 5 im Bereich der Funkenstrecke 8 kann zur Vermeidung erosionsbedingter Nachteile unterschiedlich gewählt sein.

Fig. 2 zeigt eine erste Ausführungsform. Die innere Resonatorelektrode 4, bei der es sich z. B. um ein Vollmaterialbauteil handeln kann, ist an ihrem freien Ende halbkugelförmig gerundet ausgeführt. Die äußere Resonatorelektrode 5 weist eine Ringstruktur 11 auf, die zur inneren Resonatorelektrode 4 vorspringt. Die Ringstruktur 11 verjüngt sich zu ihrem freien Ende hin. Die Funkenstrecke ist zwischen der freien Stirnkante der Ringstruktur 11 und der gegenüberliegenden Elektrodenoberfläche ausgebildet, nachdem die beiden Elektroden 4, 5 in diesem Bereich den minimalen Abstand zueinander einnehmen, wobei dieser Abstand aber über die gesamte Länge der Ringstruktur konstant ist. Es ergibt sich hier ein zweidimensionaler Abschnitt mit konstantem Elektrodenabstand, nachdem die Ringstruktur 11 sich verjüngt und an ihrem freien Ende rundlich ausgeführt ist.

Fig. 2 zeigt die Abstandsverhältnisse, die zwischen den Elektroden gegeben sind. d₁ bezeichnet den radialen Abstand der Resonatorelektroden 4, 5 zueinander. d₂ bezeichnet den Elektrodenabstand zwischen dem Boden der Resonatorelektrode 5 und der Elektrodenoberfläche der Resonatorelektrode 4, d₃ bezeichnet den minimalen Elektrodenabstand zwischen der Stirnkante der Ringstruktur 11 und der gegenüberliegenden Elektrodenoberfläche, während d₄ den Elektrodenabstand zur Seite hin beschreibt.

Generell sind d₁, d₂, d₃ und d₄ frei wählbar, sie können je nach Ausführung auch gleich sein. In jedem Fall sind sie aber größer als d₃, das heißt, d₁, d₂, d₄ > d₃. Der Elektrodenabstand d₃ ist aber in jedem Fall unter Berücksichtigung des Paschengesetzes zu wählen.

Fig. 3 zeigt eine weitere Ausführungsform der Resonatorelektroden 4, 5, wobei auch hier die entsprechenden Abstände eingetragen sind. Die Ausführung der Resonatorelektrode 5 entspricht im Wesentlichen der aus Fig. 2, auch hier ist eine Ringstruktur 11 vorgesehen, die sich jedoch etwas weiter in das Elektrodeninnere erstreckt. An der Resonatorelektrode 4 ist eine zweite Ringstruktur 12 vorgesehen, die entgegengesetzt vorspringt und deren Radius kleiner als der der Ringstruktur 11 ist. Fig. 3 zeigt ersichtlich, dass die beiden Ringstrukturen 11, 12 ineinander eingreifen. Der minimale Abstand d₃ ergibt sich hier im Bereich der Mantel- oder Seitenflächen der Ringstrukturen 11, 12, soweit diese einander gegenüberliegen. Auch hier gilt, dass d₁, d₂, d₄ > d₃ ist. Je nach Ausführung der Ringstrukturen 11, 12 ergibt sich auch hier ein zweidimensionaler Abschnitt minimalen Elektrodenabstands, also letztlich ein Kreisring minimalen Abstands. Sind die Ringstrukturen 11, 12 jedoch im Bereich ihrer Seitenflächen ebenflächig ausgeführt, ist es denkbar, einen dreidimensionalen großflächigen Abschnitt gleichen Abstands zu realisieren.

Fig. 4 zeigt eine weitere Ausführungsform der Resonatorelektroden 4, 5, wobei auch hier an beiden Resonatorelektroden 4, 5 die aus Fig. 3 bekannten Ringstrukturen 11, 12 vorgesehen sind, jedoch ist an der Resonatorelektrode 5 eine mittige Erhebung 13 vorgesehen, so dass sich letztlich zwischen der Ringstruktur 11 und der Erhebung 13 eine ringförmige Vertiefung 14 ergibt, in die die Ringstruktur 12 zum Teil eingreift. Auch hier sind wiederum die Abstandsverhältnisse eingezeichnet, wobei auch hier grundsätzlich wieder gilt, dass d₁, d₂, d₄ > d₃ ist. An dieser Stelle ist darauf hinzuweisen, dass der minimale Elektrodenabstand d₃ nicht oder nicht nur zwischen den beiden Ringstrukturen 11, 12 realisiert sein kann, vielmehr kann er auch zwischen der mittigen Erhebung 13 und der Ringstruktur 12 realisiert sein, je nach geometrischer Auslegung.

Fig. 5 zeigt eine weitere Elektrodenkonfiguration. Die Resonatorelektrode 5 weist eine Ringstruktur 11 auf, während an der Resonatorelektrode 4 eine Vertiefung 15 realisiert ist, die im gezeigten Beispiel im Wesentlichen der sich verjüngenden Form der Ringstruktur 11 entspricht. Die Ringstruktur 11 greift mit ihrem freien Ende zum Teil in die Vertiefung 15 ein. Sofern die geometrischen Verhältnisse derart sind, dass der Abstand zwischen Ringstruktur 11 und der die Vertiefung 15 begrenzenden Elektrodenoberfläche über den gesamten Bereich des Eingriffs konstant ist, kann hier eine sehr große Elektrodenfläche minimalen Abstands realisiert werden. Auch hier sind die entsprechenden Abstandsverhältnisse eingezeichnet, wobei auch hier gilt, dass d₁, d₂, d₄ > d₃ ist.

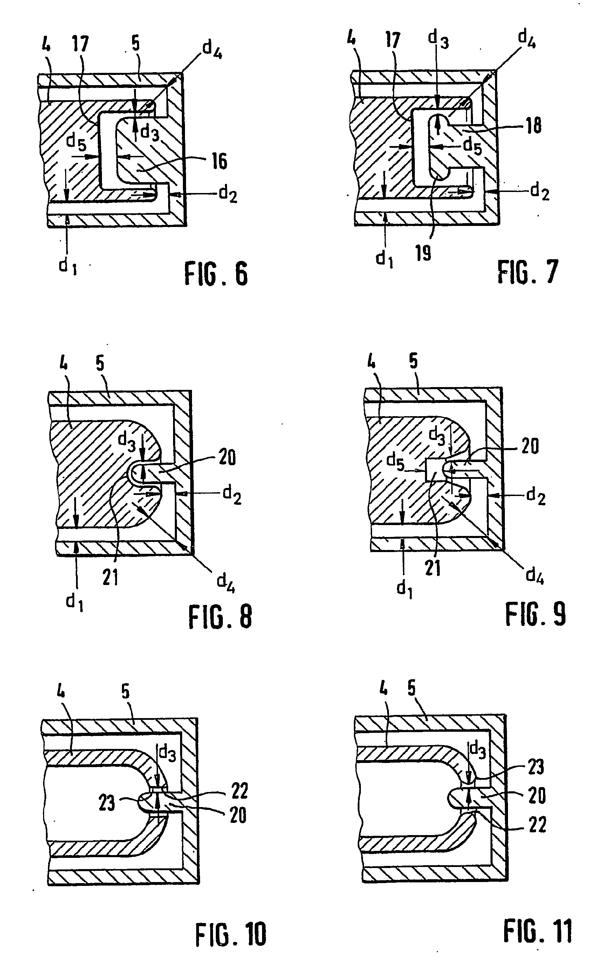

Fig. 6 zeigt eine alternative Elektrodenkonfiguration im Vergleich zu den bisher beschriebenen Ringstrukturen. An der äußeren Elektrode 5 ist eine zylindrische stempelartige Struktur 16 konstanten Durchmessers vorgesehen, die lediglich im Bereich ihres freien Endes randseitig abgerundet ist. Diese stempelartige Struktur greift in eine hohlzylindrische Ausnehmung 17 an der Resonatorelektrode 4, die ebenfalls konstanten Innendurchmesser aufweist, ein. Der minimale Elektrodenabstand d₃ ist hier über eine große Fläche realisiert. Auch hier sind wiederum die Abstandsverhältnisse eingezeichnet, wobei hier zusätzlich der Abstand d₅, der den Abstand der freien Stirnfläche der Struktur 16 zur gegenüberliegenden Bodenfläche der hohlzylindrischen Ausnehmung 17 angibt, eingezeichnet ist. Auch hier gilt, dass d₁, d₂, d₄ und d₅ frei und im Extremfall sogar gleich gewählt werden können, in jedem Fall muss aber realisiert werden, dass d₁, d₂, d₄, d₅ > d₃ ist.

Fig. 7 zeigt schließlich eine weitere Ausführungsform mit einer stempelartigen Struktur 18, die im Wesentlichen T-förmig im Querschnitt ist und einen oberen Ansatz 19 größeren Durchmessers aufweist. Die Struktur 18 greift auch hier in eine hohlzylindrische Ausnehmung 17 an der Resonatorelektrode 4 ein. Die randseitige Kante des Ansatzes 19 ist gerundet oder verjüngt ausgeführt, so dass sich infolge der Wölbung ein Punkt auf der gewölbten Fläche, an dem der minimale Abstand d₃ gegeben ist. Hier wäre also auch ein quasi zweidimensionaler Ringabschnitt minimaler Elektrodenabstands realisiert. Eine größere Fläche gleichen Abstands kann bei einer planen Ausführung des Randes des Ansatzes 19 erreicht werden.

Fig. 8 zeigt eine weitere Ausführungsform einer Elektrodenkonfiguration. An der Resonatorelektrode 5 ist eine zapfenartige Struktur 20 vorgesehen, die in eine entsprechende Ausnehmung 21 der vollen Resonatorelektrode 4 eingreift. Die zapfenartige Struktur 20 ist sich leicht verjüngend halbkugelförmig ausgeführt, die Form der Ausnehmung 21 ist entsprechend gewählt, so dass sich über die gesamte Eingriffstiefe der minimale Elektrodenabstand d₃ realisieren lässt. Auch hier sind, wie üblich, die Abstände eingetragen, wobei auch hier generell gilt, dass d₁, d₂, d₄ > d₃ ist.

Eine weitere alternative Elektrodenkonfiguration zeigt Fig. 9. Auch hier ist eine zapfenartige Struktur 20 sowie eine gegenüberliegende Ausnehmung 21 vorgesehen, diese sind jedoch formmäßig nicht aneinander angepasst. Je nachdem, wie die beiden Elektroden im Übergriffsbereich zwischen zapfenförmiger Struktur 20 und Ausnehmung 21 ausgeführt sind, ergibt sich eine mehr oder weniger große Fläche konstanten minimalen Elektrodenabstandes.

Fig. 10 zeigt eine weitere Elektrodenkonfiguration. Die Resonatorelektrode 4 ist hier als Hohlelektrode ausgeführt. Sie weist eine kreisrunde Ausnehmung 22, also eine Durchbrechung, auf, die von der zapfenartigen, endseitig gerundeten Struktur 20 durchsetzt wird. Die innere Randfläche 23, die die Ausnehmung 22 begrenzt, ist hier im Wesentlichen flächig ausgeführt, so dass sich ein großflächiger Abschnitt konstanten Elektrodenabstands, über den gezündet werden kann, ergibt.

Eine ähnliche Ausführungsform zeigt Fig. 11, jedoch ist hier die Berandungsfläche 23 gerundet ausgeführt, so dass sich hier nur ein umlaufender zweidimensionaler Kreisring konstanten Elektrodenabstands ergibt.

Die beschriebenen Ausführungsbeispiele sind nicht beschränkend. Grundlegend für die vorliegende Erfindung ist, dass die jeweilige Elektrodenkonfiguration so gewählt ist, dass sich nicht nur ein eindimensionaler Punkt minimalen Elektrodenabstands, über den die Funkenstrecke zündet, ergibt, sondern dass sich ein zwei- oder dreidimensionaler Abschnitt konstanten Elektrodenabstands ergibt, über den gezündet werden kann. Kommt es hier zu Erosionseffekten, stehen noch hinreichende weitere Abschnittsbereiche minimalen und damit optimalen Elektrodenabstands zur Verfügung, über die nachfolgende Zündvorgänge ablaufen können.

## Patentansprüche

1. Mikrowellengenerator, umfassend wenigstens einen Resonator (3) bestehend aus zwei einander gegenüberliegenden Resonatorelektroden (4, 5) die über eine bei Anliegen einer Hochspannung durchschlagende Funkenstrecke (8) getrennt sind,
wobei die Resonatorelektroden (4, 5) im Bereich der Funkenstrecke (8) derart ausgebildet sind, dass sich ein zwei- oder dreidimensionaler Abschnitt mit im Wesentlichen konstantem, minimalem Elektrodenabstand (d3) ergibt,
**dadurch gekennzeichnet,**
**dass** wenigstens eine Resonatorelektrode (4, 5) eine vorspringende Ringstruktur (11, 12) aufweist.

2. Mikrowellengenerator nach Anspruch 1,
**dadurch gekennzeichnet,**
**dass** mehrere zentralsymmetrische Ringstrukturen (11, 12) unterschiedlicher Radien vorgesehen sind.

3. Mikrowellengenerator nach Anspruch 1 oder 2,
**dadurch gekennzeichnet,**
**dass** an beiden Resonatorelektroden (4, 5) wenigstens eine Ringstruktur (11, 12) vorgesehen ist.

4. Mikrowellengenerator nach Anspruch 3,
**dadurch gekennzeichnet,**
**dass** die jeweiligen Ringstrukturen (11, 12) den gleichen Radius aufweisen und
einander gegenüberliegen, oder dass die Ringstrukturen (11, 12) unterschiedliche Radien aufweisen und die eine in die andere eingreift.

5. Mikrowellengenerator nach Anspruch 1 oder 2,
**dadurch gekennzeichnet,**
**dass** die der die Ringstruktur (11) aufweisende Resonatorelektrode (5) gegenüberliegende Resonatorelektrode (4) eine ringförmige Vertiefung (15) aufweist, in die die Ringstruktur (11) eingreift.

6. Mikrowellengenerator nach einem der Ansprüche 1 bis 5,
**dadurch gekennzeichnet,**
**dass** sich die Ringstruktur (19, 12) querschnittlich zum freien Ende hin verjüngt.

7. Mikrowellengenerator nach Anspruch 6 und 7,
**dadurch gekennzeichnet,**
**dass** sich die ringförmige Vertiefung (15) querschnittlich gesehen zum Vertiefungsgrund hin verjüngt.

8. Mikrowellengenerator, umfassend wenigstens einen Resonator (3) bestehend aus zwei einander gegenüberliegenden Resonatorelektroden (4, 5) die über eine bei Anliegen einer Hochspannung durchschlagende Funkenstrecke (8) getrennt sind, wobei die Resonatorelektroden (4, 5) im Bereich der Funkenstrecke (8) derart ausgebildet sind, dass sich ein zwei- oder dreidimensionaler Abschnitt mit im Wesentlichen konstantem, minimalem Elektrodenabstand (d3) ergibt,
**dadurch gekennzeichnet,**
**dass** die eine Resonatorelektrode (5) eine zapfen- oder stempelartige vorspringende Struktur (16, 18, 20) aufweist, die in eine Ausnehmung (17, 21) an der gegenüberliegenden Resonatorelektrode (4) eingreift.

9. Mikrowellengenerator nach Anspruch 8,
**dadurch gekennzeichnet,**
**dass** die Struktur (16, 18, 20) rotationssymmetrisch und die Ausnehmung (17, 21) hohlzylindrisch ist.

10. Mikrowellengenerator nach Anspruch 8 oder 9,
**dadurch gekennzeichnet,**
**dass** sich die zapfenartige Struktur (20) und die Ausnehmung (21) zu ihrem freien Ende bzw. zum Ausnehmungsgrund hin verjüngen.

11. Mikrowellengenerator nach einem der Ansprüche 8 bis 10,
**dadurch gekennzeichnet,**
**dass** die zapfenförmige Struktur (20) und die Ausnehmung (21) an ihrem freien Ende bzw. im Ausnehmungsgrund gerundet ausgeführt sind.

12. Mikrowellengenerator nach Anspruch 8 oder 9,
**dadurch gekennzeichnet,**
**dass** die stempelartige Struktur (18) zylindrisch oder querschnittlich gesehen T-förmig ist.

13. Mikrowellengenerator nach Anspruch 8,
**dadurch gekennzeichnet,**
**dass** die zylindrische zapfenförmige Struktur (20) eine kreisförmige Ausnehmung (22) in der gegenüberliegenden hohlen Resonatorelektrode (4) durchsetzt.

14. Mikrowellengenerator nach Anspruch 13,
**dadurch gekennzeichnet,**
**dass** der die Ausnehmung (22) begrenzende Elektrodenrand (23) querschnittlich gesehen abgerundet ausgeführt ist.

## Claims

1. Microwave generator, having at least one resonator (3) comprising two mutually opposite resonator electrodes (4, 5) which are separated by a spark gap (8) which breaks down when a high-voltage is applied, the resonator electrodes (4, 5) being designed in the area of the spark gap (8) such that they result in a two-dimensional or three-dimensional section with an essentially constant, minimum electrode separation (d₃),
**characterized**
**in that** at least one resonator electrode (4, 5) has a projecting ring structure (11, 12).

2. Microwave generator according to Claim 1,
**characterized**
**in that** a plurality of centrally-symmetrical ring structures (11, 12) of different radii are provided.

3. Microwave generator according to Claim 1 or 2,
**characterized**
**in that** at least one ring structure (11, 12) is provided on both resonator electrodes (4, 5).

4. Microwave generator according to Claim 3,
**characterized**
**in that** the respective ring structures (11, 12) have the same radius and are opposite one another, or in that the ring structures (11, 12) have different radii and one engages in the other.

5. Microwave generator according to Claim 1 or 2,
**characterized**
**in that** the resonator electrode (4) which is opposite the resonator electrode (5) that has the ring structure (11) has an annular depression (15) in which the ring structure (11) engages.

6. Microwave generator according to one of Claims 1 to 5,
**characterized**
**in that** the cross section of the ring structure (11, 12) tapers towards the free end.

7. Microwave generator according to Claim 5 and 6,
**characterized**
**in that** the cross section of the annular depression (15) tapers towards the depression base.

8. Microwave generator, having at least one resonator (3) comprising two mutually opposite resonator electrodes (4, 5) which are separated by a spark gap (8) which breaks down when a high-voltage is applied, the resonator electrodes (4, 5) being designed in the area of the spark gap (8) such that they result in a two-dimensional or three-dimensional section with an essentially constant, minimum electrode separation (d₃),
**characterized**
**in that** one resonator electrode (5) has a projecting structure (16, 18, 20) which is like a pin or stamp and engages in a recess (17, 21) on the opposite resonator electrode (4).

9. Microwave generator according to Claim 8,
**characterized**
**in that** the structure (16, 18, 20) is rotationally symmetrical, and the recess (17, 21) is hollow-cylindrical.

10. Microwave generator according to Claim 8 or 9,
**characterized**
**in that** the pin-like structure (20) and the recess (21) taper towards their free end and their recess base, respectively.

11. Microwave structure according to one of Claims 8 to 10,
**characterized**
**in that** the structure (20) which is in the form of a pin and the recess (21) are rounded at their free end and in the recess base, respectively.

12. Microwave generator according to Claim 8 or 9,
**characterized**
**in that** the stamp-like structure (18) is cylindrical or has a T-shaped cross section.

13. Microwave generator according to Claim 8,
**characterized**
**in that** the cylindrical structure (20) which is in the form of a pin passes through a circular recess (22) in the opposite hollow resonator electrode (4).

14. Microwave generator according to Claim 13,
**characterized**
**in that** the electrode edge (23) which bounds the recess (22) has a rounded cross section.

## Revendications

1. Générateur d'hyperfréquences, comprenant au moins un résonateur (3) composé de deux électrodes de résonateur (4, 5) opposées l'une à l'autre, lesquelles sont séparées par une distance de décharge (8) qui est traversée lors de l'application d'une haute tension, les électrodes de résonateur (4, 5) étant configurées dans la zone de la distance de décharge (8) de telle sorte qu'il se produit une section bi- ou tridimensionnelle avec un écart minimum entre les électrodes (d3) pour l'essentiel constant, **caractérisé en ce qu'**au moins une électrode de résonateur (4, 5) présente une structure annulaire (11, 12) en saillie.

2. Générateur d'hyperfréquences selon la revendication 1, **caractérisé en ce que** sont prévues plusieurs structures annulaires (11, 12) symétriques par rapport au centre ayant des rayons différents.

3. Générateur d'hyperfréquences selon la revendication 1 ou 2, **caractérisé en ce qu'**au moins une structure annulaire (11, 12) est prévue sur les deux électrodes de résonateur (4, 5).

4. Générateur d'hyperfréquences selon la revendication 3, **caractérisé en ce que** les structures annulaires (11, 12) respectives présentent le même rayon et sont opposées l'une à l'autre, ou **en ce que** les structures annulaires (11, 12) présentent des rayons différents et l'une pénètre dans l'autre.

5. Générateur d'hyperfréquences selon la revendication 1 ou 2, **caractérisé en ce que** l'électrode de résonateur (4) opposée à l'électrode de résonateur (5) qui présente la structure annulaire (11) présente un enfoncement en forme d'anneau (15) dans lequel pénètre la structure annulaire (11).

6. Générateur d'hyperfréquences selon l'une des revendications 1 à 5, **caractérisé en ce que** la section transversale de la structure annulaire (11, 12) s'amincit en direction de l'extrémité libre.

7. Générateur d'hyperfréquences selon la revendication 5 ou 6, **caractérisé en ce que**, vu dans sa section transversale, l'enfoncement en forme d'anneau (15) s'amincit en direction de la base de l'enfoncement.

8. Générateur d'hyperfréquences, comprenant au moins un résonateur (3) composé de deux électrodes de résonateur (4, 5) opposées l'une à l'autre, lesquelles sont séparées par une distance de décharge (8) qui est traversée lors de l'application d'une haute tension, les électrodes de résonateur (4, 5) étant configurées dans la zone de la distance de décharge (8) de telle sorte qu'il se produit une section bi- ou tridimensionnelle avec un écart minimum entre les électrodes (d3) pour l'essentiel constant, **caractérisé en ce que** l'une des électrodes de résonateur (5) présente une structure (16, 18, 20) en saillie de type tenon ou poinçon qui pénètre dans un évidement (17, 21) de l'électrode de résonateur (4) opposée.

9. Générateur d'hyperfréquences selon la revendication 8, **caractérisé en ce que** la structure (16, 18, 20) est à symétrie rotationnelle et l'évidement (17, 21) est cylindrique creux.

10. Générateur d'hyperfréquences selon la revendication 8 ou 9, **caractérisé en ce que** la structure en forme de tenon (20) et l'évidement (21) se rétrécissent vers leur extrémité libre ou vers le fond de l'évidement.

11. Générateur d'hyperfréquences selon l'une des revendications 8 à 10, **caractérisé en ce que** la structure en forme de tenon (20) et l'évidement (21) sont réalisés arrondis à leur extrémité libre ou dans le fond de l'évidement.

12. Générateur d'hyperfréquences selon la revendication 8 ou 9, **caractérisé en ce que** la structure en forme de poinçon (18) est cylindrique ou, vue en section transversale, en forme de T.

13. Générateur d'hyperfréquences selon la revendication 8, **caractérisé en ce que** la structure en forme de tenon (20) s'engage dans un évidement de forme circulaire (22) dans l'électrode de résonateur (4) creuse opposée.

14. Générateur d'hyperfréquences selon la revendication 13, **caractérisé en ce que** le bord d'électrode (23) qui délimite l'évidement (22) présente une section transversale arrondie.
